# EUROPEAN PATENT APPLICATION

(11) **EP 3 038 169 A1**
(43) Date of publication of application: **29.06.2016**
(21) Application number: 14199551.4
(22) Date of filing: 22.12.2014
(51) Int. Cl.: H01L 31/18, H01L 31/0236, H01L 21/3065

(54) **Process for the manufacture of solar cells**

(71) Applicant: Solvay SA, 1120 Bruxelles (BE)
(72) Inventor: The designation of the inventor has not yet been filed
(74) Representative: Mross, Stefan P.M.

(57) **Abstract**

The present invention relates to a method for manufacturing a solar cell from a silicon wafer comprising a step of etching the silicon wafer with specific gas mixtures comprising fluorine, hydrogen fluoride, one or more inert gases and optionally one or more a further gases, to silicon wafers produced using said method as well as to the use of said gas mixtures.

## Description

The present invention relates to a method for manufacturing a solar cell from a silicon wafer comprising a step of etching the silicon wafer with specific gas mixtures comprising fluorine, hydrogen fluoride, one or more inert gases and optionally one or more a further gases.

Solar cells are applied to convert solar light into electric current. They are usually manufactured from monocrystalline blocks of boron-doped silicon (P-type doping) or from cast silicon ingots (polycrystalline silicon, P-type doped with boron) by sawing wafers in desired size from the bulk material.

The wafers thus obtained can optionally be treated with elemental fluorine (F₂) or carbonyl fluoride (COF₂) as described in WO 2009/092453.

However, there is still a need for improved methods for the modification of the surface of a silicon wafer.

Now therefore, the present invention provides methods that advantageously lead to an improved etch rate, an improved etch depth into the silicon wafer, and/or an improved surface texturing. The solar cells thus provided show advantageously an increased efficiency and/or an increased durability.

Accordingly, the present invention concerns in a first aspect a method for manufacturing a solar cell from a silicon wafer comprising a step of etching the silicon wafer with a gas mixture consisting of 0.1 to 20 vol% F₂, 2.5 to 1.000 ppmv HF, optionally a further gas with one or more inert gases being the balance to 100 vol%.

In a preferred embodiment, the gas mixture consists of 0.5 to 5 vol% F₂, 5 to 100 ppmv HF with one or more inert gases being the balance to 100 vol%, more preferably the gas mixture consists of 1 to 5 vol% F₂, 10 to 50 ppmv HF with one or more inert gases being the balance to 100 vol%.

The term "ppmv" is intended to denote parts per million by volume, i.e. 1 part of volume to 1 million parts of volume. Likewise, the term "vol%" is intended to denote a certain percentage of the total volume of the gas mixture.

The gas mixture can be formed in the reactor by introducing the discrete single components into the reactors through a static mixer by themselves, or a gas mixture of the individual components is formed before introducing it into the reactor. If the gases are introduced in such a premixed form into the reactor, a homogenous or near-homogenous mixture can be provided throughout the reactor chamber. In general, the gas mixture can be supplied from pressurized bottles. In such pressurized bottles, a homogenous mixture forms. It is also possible to introduce the gas constituents separately into the reactor. It is also possible to introduce a premixed gas mixture with some of the components together with another gas or gas mixture simultaneously into the reactor.

In the context of this invention, the term "gas mixture" denotes premixed gas mixtures as well as mixtures created in the plasma reactor. It should be noted that the HF in the gas mixture can be added as neat HF to a preformed gas mixture of or more of the other constituents. Alternatively, the HF can also be provided by adding the corresponding amount of water/moisture to the fluorine-comprising gas mixture, upon which HF is formed as a reaction product of the reaction of F₂ and water. In this case, one or more further gases, including the other reaction products from this reaction, e.g. oxygen, are comprised in the gas mixture.

The atmosphere at the production site, i.e. the clean rooms, for the silicon wafers is generally controlled to maintain a standard temperature and moisture. Thus, the HF can also be generated at a controlled level by passing a gas mixture through a plastic tube, preferably made from PTFE or PVDF, for a defined time and tube length. As the conditions in the clean rooms are constant, the moisture uptake is constant as well. Thus, instead of providing a gas cylinder with a certain specific water or HF concentration, the gas mixture or one of its components, e.g. the inert gas, can be passed through the plastic tube for a specified time and tube length. The moisture is then converted to HF by reaction with F₂ as explained above. The alternative reduces the cost as for example commercially available electronic grade N₂ can be used without the need to mix it with a certain amount of HF or water.

The term "inert gas" is intended to denote a gas that does not react with the other gases present and neither with the solar wafer. Suitable examples include N₂, Ar, He, Ne, Kr and mixtures thereof, preferred are N₂ and/or Ar, notably N₂.

Additional gases may optionally also be present in the mixture. Suitable examples include O₂, COF₂, N₂O, SF₆, NF₃, and mixtures thereof.

In another preferred embodiment, the step of etching the silicon wafer with the gas mixture is a step of texturing the surface of the solar wafer said step being suitable to increase the efficiency of the solar cell. Without being bound to a theory, the texturing step is believed to created craters of defined depths and shape in the silicon wafer material. This texturing step enables the silicon wafer material to absorb a greater proportion of the sun light.

It has been surprisingly found that the use of a defined amount of HF as specified in the present invention has an advantageous effect on the etch rate as well as the etch depth achieved with the inventive gas mixtures. Additionally, the presence of the HF in the gas mixture leads to a texture on the surface of the silicon wafer which further leads to an improved efficiency of the solar cells prepared from these silicon wafers. It is believed that the texturing of the wafer surface by the etching reduces the reflectivity and thus enhances the effectivity of the solar cell. Reflectivity is considered reduced if the total hemispherical reflectivity (averaged over all wavelengths) expressed by the intensity of incident light divided by reflected light is smaller for the surface-treated silicon wafer in relation to the untreated silicon wafer.

Without being bound to a theory, it is believed that the HF has at least partially a catalytic activity in the etching process. The HF is believed to react faster with the SiO₂ of the silicon wafer, forming products including SiF₄ and water. The water formed can subsequently react with the fluorine present in the gas mixture to form additional amounts of HF.

The etching treatment is performed for a time which is sufficient to provide the desired texture of the surface for mass production in dry etching processes. Preferably, the treatment is performed for equal to or more than 1 second. Preferably, the treatment is performed for equal to or less than 10 minutes, preferably for equal to or less than 5 minutes. Etching is preferably performed until about equal to or more than 0.1 µm of the surface are etched away. Preferably, it is performed until equal to or less than 500 µm, preferably, until equal to or less than 100 µm are etched away from the surface, especially until equal to or less than 20 µm are etched away. Often, a few µm are etched away, for example equal to or less than 10 or even equal to or less than 5 µm.

The silicon wafer can be of 200 mm, 300 mm, 400 mm, or 500 mm diameter.

The flow rate of the gas mixture is chosen between 1.000 and 50.000 sccm, preferably 20.000 sccm.

The etching can also be applied to the rear side of the solar cell to improve adhesion of the electrodes which are applied, as is described below.

The etching can be performed on any conventional equipment used for such purpose. The etching can be performed thermally or assisted by a plasma source. Preferably, the etching is performed thermally.

During the etching treatment, the wafer might heat up. So, if needed, either the wafer can be cooled if a threat of overheating exists, or the treatment must be interrupted from time to time so that the wafer cools down. Preferably, the step of etching the silicon wafer with the gas mixture is performed at a temperature from 200 to 400 °C. Thus, the silicon wafer needs to either be heated to this temperature or cooled to this temperature. More preferably, the step is performed at a temperature of around 250 °C, 300 °C, or, or 350 °C.

The pressure inside the etching chamber is preferably atmospheric pressure, i.e. is chosen between 740 and 760 Torr. Alternatively, the etching can be performed at a pressure below atmospheric pressure, e.g. at 10, 20, 50, 100, 200, 300, 400, or 500 Torr.

The silicon wafers treated prepared according to the present invention can be further treated to produce a solar cell. Especially, contact electrodes are applied. These contact electrodes are needed to withdraw electric current (usually direct current) from the cell. A preferred way to apply contact electrodes is evaporating metal onto the wafer as mentioned in US-A 4249957. A contact electrode from titanium-palladium-silver is very suitable. There are alternative methods which can be used to apply contact electrodes. For example, a paste can be applied which contains conductive particles, e.g. silver particles, to form a pattern on the wafer, the wafer is fired, and a conductive pattern is formed on the wafer which functions as electrode. This alternative is described in EP-A-0 542148.

Another aspect of the present invention is a solar cell obtained by the process of the present invention. In one embodiment, cells containing a wafer which was surface-etched have a very low degree of reflexivity. The invention also concerns a solar panel obtained by assembling a plurality of solar cells obtained in the process of the present invention. "A plurality" denotes at least two solar cells. The upper limit is given from practical reasons. Preferably, equal to or less than 10 solar cells, more preferably, at least 20 solar cells are assembled to provide a solar panel.

It has been surprisingly found the HF content in the gas mixture used for the texturing step has great influence on the etching rate, the etch depth and the etching pattern of the etching step. Accordingly, another aspect of the present invention is the use or a method of using a gas mixture with a defined content of HF for texturing the surface of a silicon wafer. Preferably, the gas mixture consists of 0.1 to 20 vol% F₂, 2.5 to 1.000 ppmv HF, optionally a further gas with one or more inert gases being the balance to 100 vol%. In a preferred embodiment of this aspect, the gas mixture consists of 0.5 to 5 vol% F₂, 5 to 100 ppmv HF with one or more inert gases being the balance to 100 vol%, more preferably the gas mixture consists of 1 to 5 vol% F₂, 10 to 50 ppmv HF with one or more inert gases being the balance to 100 vol%.

The following examples are intended to explain the invention further without intending to limit it.

### Examples :

### Example 1: Texturing of a silicon wafer

A 200 mm plain silicon wafer without structure is dry etched in a microwave plasma etcher manufactured by Secon Semiconductor Equipment GmbH, Austria. The wafers are weighed before and after etching, the difference in weight indicates the etch rate. The etch depth achieved by the texturing is measured by optical laser measuring and can be performed on a Proforma 200SA (MTI instruments inc.).

The wafer is placed in the etching chamber and the heater maintained a temperature of 300 °C. Thermal etching, i.e. etching with the plasma source being switched off, commences with a gas mixture consisting of 20 vol% F₂, 200 ppmv HF, and N₂ being the balance to 100 vol% at a flow rate of 20 sccm at atmospheric pressure (755 Torr). The thermal etching process is performed for 60 s. A control experiment is conducted using the same parameters as described above using an ultrapure gas mixture consisting of 20 vol% F₂ and 80 vol% N₂ with an HF content of below 1 ppm.

Etch depth analysis shows that the etch depth achieved with the gas mixture comprising 200 ppmv HF shows an up to fourfold improvement compared to the ultrapure gas mixture comprising 1 ppmv HF.

### Example 2: Applying electrodes to the treated wafer

A silicon wafer treated according to the procedure outlined in example 1 is further processes to apply electrodes as described in EP-A-0 542148. A paste containing silver and, as inorganic binder, lead oxide and silicon dioxide is applied on the front side of the wafer by screen printing according to the desired pattern of the electrode structure. On the back side, a similar electrode paste is applied which further contains aluminium. The wafer is then fired at around 800°C. The pattern is then galvanized in a bath containing silver chloride and sodium thiosulfate.

The solar cell thus manufactured shows an improved efficiency compared to a solar cell manufactured using untreated silicon wafers.

## Claims

1. A method for manufacturing a solar cell from a silicon wafer comprising a step of etching the silicon wafer with a gas mixture consisting of 0.1 to 20 vol% F₂, 2.5 to 1.000 ppmv HF, optionally a further gas with one or more inert gases being the balance to 100 vol%.

2. The method according to claim 1 wherein the gas mixture consists of 0.5 to 5 vol% F₂, 5 to 100 ppmv HF with one or more inert gases being the balance to 100 vol%.

3. The method of claim 1 or 2 wherein the gas mixture consists of 1 to 5 vol% F₂, 10 to 50 ppmv HF with one or more inert gases being the balance to 100 vol%.

4. The method according to any one of claims 1 to 3 wherein the step of etching the silicon wafer with the gas mixture is a step of texturing the surface of the solar wafer said step being suitable to increase the efficiency of the solar cell.

5. The method according to any one of claims 1 to 4 wherein the one or more inert gas is chosen from N₂ or Ar, preferably the inert gas is nitrogen.

6. The method according to any one of claims 1 to 5 wherein the optionally further gas is chosen from O₂, N₂O and NF₃.

7. The method according to any one of claims 1 to 6 wherein the step of etching the silicon wafer with the gas mixture is performed thermally, preferably thermally at a temperature from 200 to 400 °C.

8. A method for manufacturing a solar panel wherein two or more solar cells manufactured by a method according to any one of claims 1 to 7 are assembled.

9. A solar cell obtained by the process of any one of claims 1 to 7.

10. A solar panel obtained by the process of claim 8.

11. Use of a gas mixture with a defined content of HF for texturing the surface of a silicon wafer.

12. The use of claim 11 wherein the gas mixture consists of 0.1 to 20 vol% F₂, 2.5 to 1.000 ppmv HF, optionally a further gas with one or more inert gases being the balance to 100 vol%.
